# EUROPEAN PATENT APPLICATION

(11) **EP 4 654 253 A2**
(43) Date of publication of application: **26.11.2025**
(21) Application number: 25171939.9
(22) Date of filing: 23.04.2025
(51) Int. Cl.: H01L 21/68

(54) **STAGE DEVICE, CHARGED PARTICLE BEAM APPARATUS, AND VACUUM DEVICE**

(30) Priority: 21.05.2024 JP 2024082295
(71) Applicant: Hitachi High-Tech Corporation, Minato-ku Tokyo 105-6409 (JP)
(72) Inventor: TAKAHASHI, Motohiro, Tokyo, 100-8280 (JP); MIZUOCHI, Masaki, Tokyo, 105-6409 (JP); YAMAMOTO, Raifu, Tokyo, 105-6409 (JP); HOSOBUCHI, Keiichiro, Tokyo, 105-6409 (JP); KATO, Takanori, Tokyo, 100-8280 (JP)
(74) Representative: Strehl & Partner mbB

(57) **Abstract**

Bottom surfaces of a plurality of magnets are coupled by a movable yoke to form a magnetic circuit, and a plurality of coils are detached (separated) from the movable yoke and fixed to a coil fixing portion that is a heat discharging path member, thereby restricting thermal deformation due to temperature fluctuation of a levitation portion. In other words, in a Z-axis motor used for gravity compensation and thrust generation in a vertical direction of a magnetic levitation stage, the movable yoke covering the bottom surfaces of the plurality of magnets whose magnetic fluxes are directed in the vertical direction and are different in direction is provided, and the plurality of coils are arranged separately from the movable yoke and at intervals from the plurality of magnets.

## Description

### BACKGROUND OF THE INVENTION

### 1. Field of the Invention

The present disclosure relates to a stage device, a charged particle beam apparatus, and a vacuum device.

### 2. Description of Related Art

A technique related to a device stage for a semiconductor-related device and a magnetic levitation stage for accurately positioning and supporting a wafer in the related art has been known. PTL 1 discloses a configuration of a magnetic levitation stage that positions a substrate in a non-contact manner. In this magnetic levitation stage mechanism, for gravity compensation and position control in a Z direction, a reluctance motor is used that controls gravity compensation by a magnetic attraction force and controls thrust in the Z direction by increasing or decreasing the magnetic attraction force by a coil current. In PTL 1, a gap sensor is disposed in the vicinity of the reluctance motor, and positioning in the Z direction is performed by controlling a levitation amount, thereby realizing non-contact support of a levitation portion.

### Citation List

### Patent Literature

PTL 1: JP2015-111714A

### SUMMARY OF THE INVENTION

For example, in processes such as manufacturing, measurement, and inspection of a semiconductor wafer, the stage device in the related art is used to accurately position the semiconductor wafer. In such a stage device, performance of positioning the semiconductor wafer at highspeed and with high accuracy is required. However, in the magnetic levitation stage device in which the reluctance motor in the related art is used as a Z motor (hereinafter, also referred to as a Z-axis motor) as in PTL 1, there is a problem that, due to a cable bending reaction force by a cable that transmits a signal or power to the levitation portion, magnetization variation of a permanent magnet of the reluctance motor, and gap fluctuation caused by a component processing error, a coil current value in the reluctance motor fluctuates and a heat generation amount of the Z motor fluctuates, and thus thermal deformation of the levitation portion occurs and accurate positioning is difficult. In addition, due to a leakage magnetic field from the permanent magnet for gravity compensation, it is difficult to apply the magnetic levitation stage device to a charged particle beam apparatus such as a scanning electron microscope.

The present disclosure provides a stage device, a charged particle beam apparatus, and a vacuum device capable of performing highly accurate positioning and having a small leakage magnetic field by restricting thermal deformation due to temperature fluctuation of a levitation portion.

According to an aspect of the present disclosure, a stage device includes: a base; a stage configured to support an object to be positioned on the base; and a Z-axis motor configured to magnetically levitate and position the stage. The Z-axis motor includes a guide yoke provided on the base, and a movable element provided on the stage so as to face the guide yoke in a vertical direction. The movable element includes: a plurality of magnets that are arranged at intervals in a horizontal direction so as to face the guide yoke in the vertical direction and whose magnetic fluxes are oriented in the vertical direction and are opposite to each other; a movable yoke covering a surface of each of the plurality of magnets on a side opposite to a guide yoke side; and a plurality of coils arranged at intervals in the horizontal direction, at positions spaced apart in the vertical direction from surfaces of the plurality of magnets on the guide yoke side. The Z-axis motor magnetically levitates the stage by moving the movable element in the vertical direction with respect to the guide yoke by an electromagnetic force of the plurality of magnets and the guide yoke.

According to the above aspect of the present disclosure, it is possible to provide a stage device, a charged particle beam apparatus, and a vacuum device capable of performing highly accurate positioning by restricting thermal deformation due to temperature fluctuation of a levitation portion and capable of performing positioning while restricting leakage and fluctuation of a magnetic field.

### BRIEF DESCRIPTION OF THE DRAWINGS

FIG. 1 is a perspective view of a stage structure using a rolling guide in the related art.
FIG. 2 is a perspective view of a stage structure using a magnetic levitation guide.
FIG. 3 is a perspective view illustrating a configuration example of a magnetic levitation stage equipped with a Z motor according to an embodiment of the present disclosure.
FIG. 4 is a schematic cross-sectional view in a YZ plane of the magnetic levitation stage equipped with a Z motor according to the embodiment of the present disclosure.
FIG. 5 is a diagram illustrating an operation principle of a reluctance motor.
FIG. 6 is a diagram illustrating a configuration example of a reluctance motor in the related art.
FIG. 7 is a diagram illustrating a configuration example of a reluctance motor according to an embodiment of the present disclosure.
FIG. 8 is a diagram illustrating details of a heat discharging structure of the reluctance motor according to the embodiment of the present disclosure.
FIG. 9 is a diagram illustrating magnetic field leakage of the reluctance motor in the related art.
FIG. 10 is a diagram illustrating a magnetic field leakage reduction effect of the reluctance motor according to the embodiment of the present disclosure.
FIG. 11 is a configuration diagram in which a position reference block is mounted on the reluctance motor according to the embodiment of the present disclosure.
FIG. 12 is a perspective view illustrating a configuration example of a magnetic levitation stage according to another embodiment of the present disclosure in which a magnetic levitation guide is used as an upper shaft and a rolling guide is used as a lower shaft.
FIG. 13 is a schematic cross-sectional view in a YZ plane of the magnetic levitation stage according to another
embodiment of the present disclosure in which a magnetic levitation guide is used as an upper shaft and a rolling guide is used as a lower shaft.

FIG. 14 is a diagram illustrating a semiconductor measurement apparatus that is an example of application to a charged particle beam apparatus and a vacuum device.

### DESCRIPTION OF EMBODIMENTS

Hereinafter, embodiments of a stage device, a charged particle beam apparatus, and a vacuum device according to the present disclosure will be described with reference to the drawings. In the following description, a stage having a stroke of several hundred mm in one axial direction (X direction) or a stacked stage having a stroke of several hundred mm in two axial directions (X direction and Y direction) will be described.

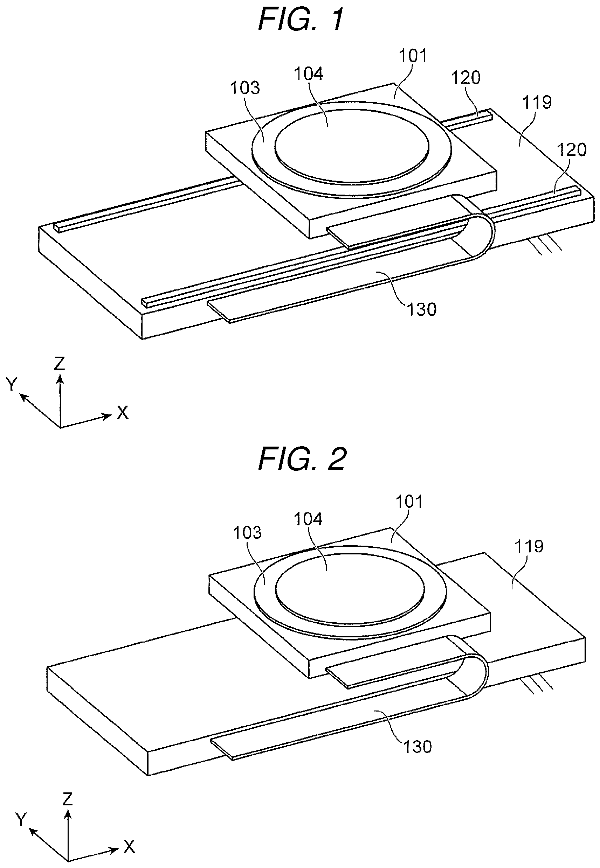

FIG. 1 is a diagram illustrating a configuration of a stage in which a rolling guide in the related art is used. FIG. 1 is a configuration example of a uniaxial stage that uses a rolling guide and is movable in an X-axis direction. In this stage configuration, a top table 101 is guided by an X guide 120 on a base 119 and moves in the X-axis direction. A sample 104, which is an object to be positioned, is placed on a sample stage 103 disposed on the top table 101. In this stage configuration, since a contact type rolling guide is used, a bending reaction force of a wiring 130 such as a flat cable is supported by guide rigidity.

FIG. 2 illustrates a configuration example of a stage (magnetic levitation stage) in which a magnetic levitation guide is used. The X guide 120 is converted into a magnetic levitation guide for the stage in FIG. 1. In the magnetic levitation stage, it is necessary to control the position and posture of a movable portion with 6 degrees of freedom of displacement in XYZ directions and rotation around XYZ axes. Therefore, in the stage illustrated in FIG. 1 in which the guide is not a magnetic levitation guide, only one motor is required as a drive element, whereas in the stage illustrated in FIG. 2 in which a magnetic levitation guide is used, the number of axes of the motor as the drive element increases to six. Specifically, the X guide 120 in FIG. 1 restricts displacement in the Y direction and the Z direction, and this function is implemented by a Y motor and a Z motor in substitution.

In the magnetic levitation stage in FIG. 2, since the guide is a non-contact magnetic levitation guide, the bending reaction force in the Z direction of the wiring 130 such as a flat cable is supported by a thrust of the Z motor. In general, although the cable bending reaction force is smaller than a thrust required at the time of acceleration and deceleration of the stage, since the cable bending reaction force is always applied not only during moving of the stage but also during stop of the stage, a constant current is always applied to the Z coil, and heat generation of the Z motor is a problem. In particular, in the magnetic levitation stage, when a water cooling pipe for cooling coils of a levitation portion and a sensor such as a scale head is provided in a flat cable, the cable bending reaction force is larger than that in the stage in which a rolling guide is used. In addition, since the cable bending reaction force changes depending on the position and has an individual difference, heat generation fluctuation of the Z motor due to a table position or a machine difference occurs, and thermal deformation of the top table 101 and the sample 104 occurs, which causes a variation in visual field positioning accuracy.

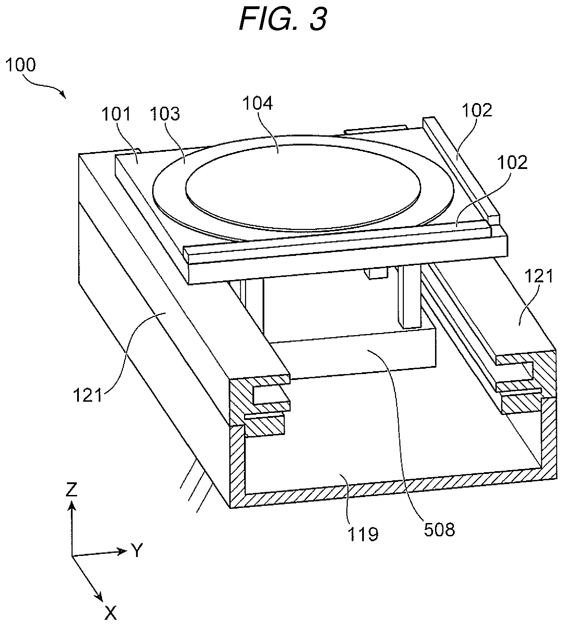

FIG. 3 illustrates a configuration example of a magnetic levitation stage equipped with a Z motor according to an embodiment of the present disclosure. The magnetic levitation stage is a uniaxial stage having a long stroke in the X direction, and is equipped with a magnetic levitation guide that guides the top table 101 movable in the X direction. A stage device 100 illustrated in FIG. 3 includes, in a longitudinal direction of the base 119, a linear motor that generates a thrust in the X direction and the Y direction and a magnetic levitation guide 121 that outputs a thrust in the Z direction. In addition, a water cooling jacket 508 is mounted on a levitation portion including the top table 101 on which the sample 104 is placed, and a bar mirror 102 is mounted on the top table 101 on which the sample 104 is placed. The sample 104 is placed on the sample stage 103 installed on the top table 101, and positions of the top table 101 and the sample 104 in the X direction and the Y direction can be grasped by irradiating the bar mirror 102 with laser light from a laser interferometer described later and detecting reflected light. The water cooling jacket 508 is installed to discharge or dissipate (exhaust) heat generated from coils of the levitation portion to cool the coils of the levitation portion and a sensor such as a scale head. The water cooling jacket 508 may be a heat discharging portion using other cooling means. The heat discharging portion may be any unit as long as the unit can discharge or dissipate (exhaust) heat generated from the coils of the levitation portion to cool the coils, and examples thereof include a cooling jacket using another refrigerant, a fin, and a Peltier element.

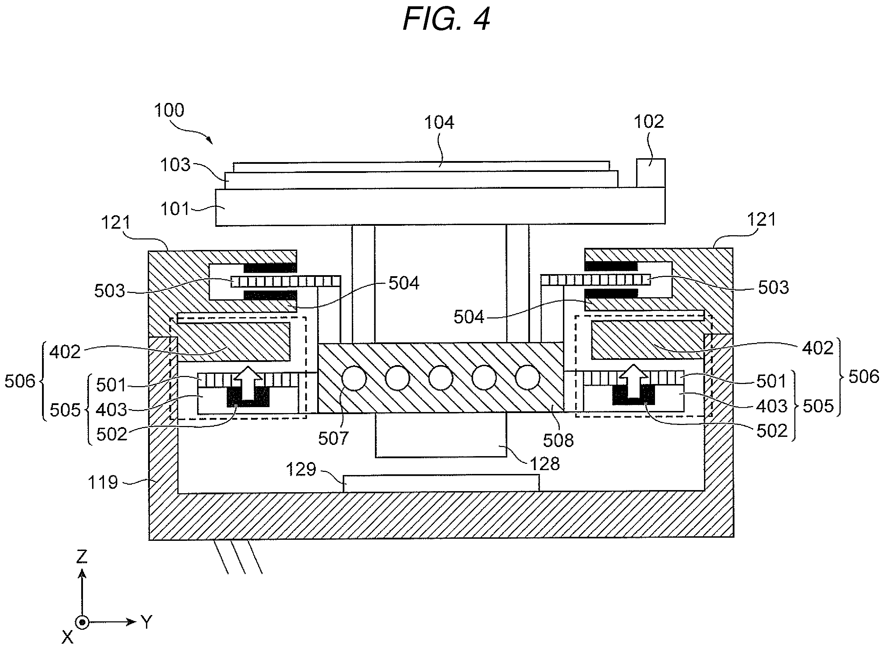

FIG. 4 illustrates a schematic cross-sectional view in a YZ plane of the magnetic levitation stage according to the embodiment of the present disclosure as illustrated in FIG. 3 on which the Z motor is mounted. The levitation portion mainly includes the water cooling jacket 508 and the top table 101. A yoke 504 and a coil 503 of a linear motor (also referred to as X and Y motors or X and Y-axis motors) that generates a thrust in the X direction and the Y direction are fixed to (the magnetic levitation guide 121 attached to) the base 119 and the water cooling jacket 508, respectively. A coil (hereinafter, also referred to as a Z coil) 501, a permanent magnet (hereinafter, also simply referred to as a magnet) 502, and a movable yoke (hereinafter, also referred to as a back yoke) 403 of a Z motor 506 that generates a thrust in the Z direction are fixed to the water cooling jacket 508. Further, a guide yoke 402 of the Z motor 506 that generates a thrust in the Z direction is fixed to (the magnetic levitation guide 121 attached to) the base 119. (The magnetic levitation guide 121 provided with) The movable yoke 403 and the guide yoke 402 are made of a magnetic material such as SS400. That is, the stage device 100 of the embodiment includes the Z motor 506 used for gravity compensation and thrust generation in a vertical direction (Z direction) for the levitation portion in order to magnetically levitate and position the levitation portion including the top table 101 and the like. The Z motor 506 includes the guide yoke 402 that is a stator fixed to the base 119, and a movable element 505 (details will be described later). The movable element 505 is fixed to the water cooling jacket 508 so as to face the guide yoke 402 from below in the vertical direction (Z direction), and includes a coil 501, a permanent magnet 502, and the movable yoke (back yoke) 403. A water cooling pipe 507 through which water as a refrigerant flows is embedded in the water cooling jacket 508. A position and a posture of a scale plate 129 fixed to a bottom portion of the base 119 are measured by a scale head 128 fixed to a lower portion of the water cooling jacket 508.

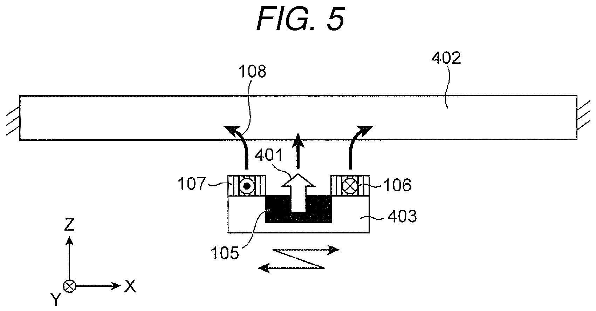

An operation principle of a reluctance motor will be described with reference to FIG. 5. A magnetic attraction force 401 between a permanent magnet 105 and the guide yoke 402 facing the permanent magnet 105 from above in the vertical direction (Z direction) is used for gravity compensation of the levitation portion. A magnetic flux 108 is formed in a loop shape inside the guide yoke 402 and the back yoke 403. When a current 106 flows through a coil 107, the magnetic flux 108 is increased or decreased, and the magnetic attraction force 401 between the permanent magnet 105 and the guide yoke 402 is increased or decreased. Accordingly, it is possible to control a force in the Z direction acting on the levitation portion. As described above, a motor of a type in which the magnetic attraction force 401 is controlled by a coil current is generally referred to as a reluctance motor. In the Z-axis motor 506, in order to restrict heat generation of the motor and reduce visual field deviation due to the thermal deformation, it is necessary to cancel a moment in a pitching direction due to acceleration and deceleration while holding a gravity load of the levitation portion with zero current, and thus it is effective to use the reluctance motor.

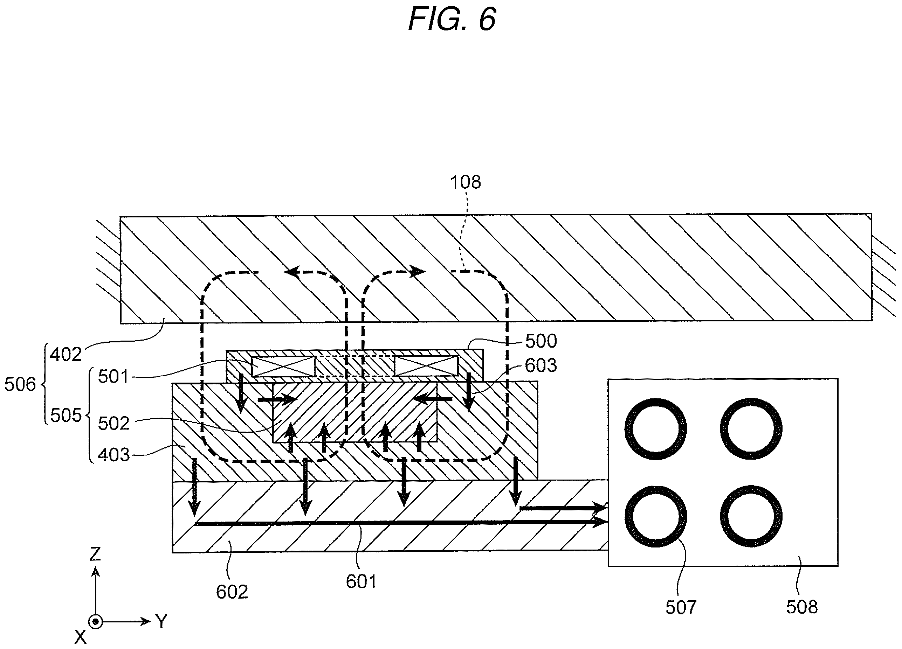

FIG. 6 illustrates a configuration example of a reluctance motor in the related art. In the reluctance motor (Z motor 506) having a structure in the related art, a periphery (bottom surface and side surfaces) of the permanent magnet 502 is surrounded by the movable yoke 403, and the coil 501 is disposed on an upper surface of the movable yoke 403. The coil 501 is molded with a molding resin 500. A coil fixing portion 602 is coupled to a lower surface of the movable yoke 403, and the movable yoke 403 is connected to the water cooling jacket 508 via the coil fixing portion 602. With this structure, it is possible to provide a heat discharging path 601 that guides generated heat 603 from the coil 501 to the water cooling jacket 508 via the movable yoke 403 and the coil fixing portion 602. The magnetic flux 108 generated by the permanent magnet 502 and the movable yoke 403 is increased or decreased by the current in the coil 501, and an amount of change in the magnetic attraction force between the guide yoke 402 and the permanent magnet 502 is used as a thrust in the Z direction. In the case of this structure, since the coil 501 is fixed to the movable yoke 403 made of a material such as SS400 having a relatively low thermal conductivity, the generated heat 603 of the coil 501 is unlikely to escape to the water cooling jacket 508, and a temperature of the Z motor 506 is likely to rise greatly. Therefore, the amount of heat transfer to the top table 101 increases, and thus the visual field deviation increases. In addition, a temperature of the permanent magnet 502 surrounded by the movable yoke 403 is likely to rise, and there is a risk that the permanent magnet 502 is thermally demagnetized. When the permanent magnet 502 is thermally demagnetized, the magnetic attraction force between the permanent magnet 502 and the guide yoke 402 decreases, and in order to maintain the gravity compensation of the levitation portion, the current in the Z coil 501 is increased, leading to an increase in the heat generation of the Z coil 501 and further thermal demagnetization of the permanent magnet 502, which is a vicious circle.

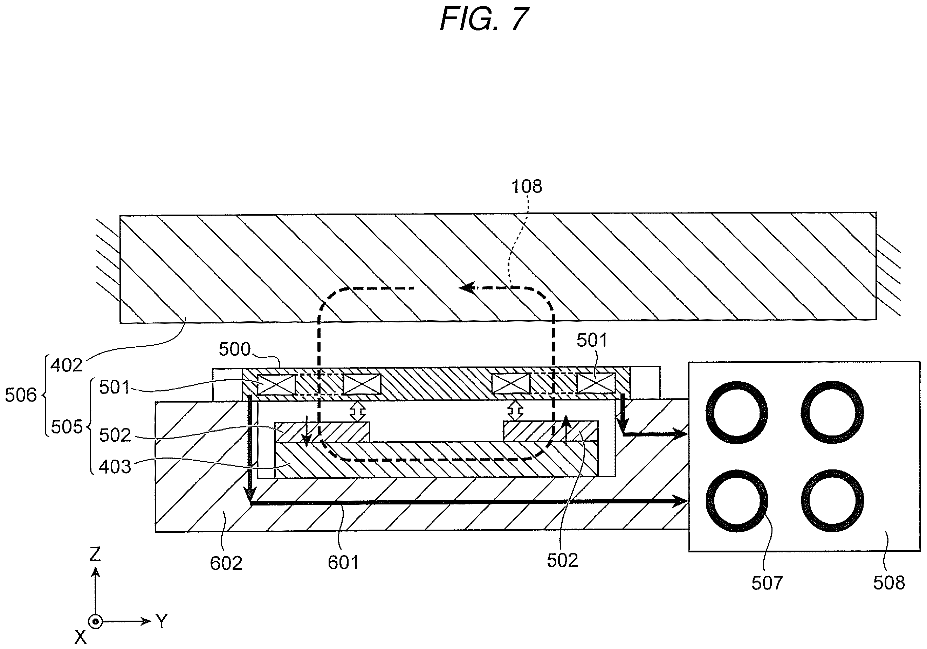

FIG. 7 illustrates a structure of a temperature-stabilized reluctance motor according to an embodiment of the present disclosure for solving these problems. The reluctance motor (Z motor 506) of this structure has a compact magnetic circuit structure in which a plurality of permanent magnets 502 are arranged at intervals (spaced apart) from each other in a horizontal direction perpendicular to the vertical direction so as to face the guide yoke 402 from below in the vertical direction, and bottom surfaces (surfaces on a side opposite to the guide yoke 402 side) of the plurality of permanent magnets 502 are connected (covered) by the flat plate-shaped movable yoke 403. Side surfaces and an upper surface other than the bottom surface of each of the plurality of permanent magnets 502 are exposed without being covered with the movable yoke 403. As long as the movable yoke 403 can cover the bottom surface of each of the plurality of permanent magnets 502, the movable yoke 403 may be formed of one member as illustrated or may be formed of multiple members. Further, a shape of the movable yoke 403 is not limited to the illustrated shape. The movable yoke 403, to whose upper surface the plurality of permanent magnets 502 are fixed (connected) as described above, is fixed (connected) to a recess provided in the coil fixing portion 602 in a posture in which side surfaces of the permanent magnet 502 and the movable yoke 403 do not come into contact with the coil fixing portion 602. Further, in the reluctance motor (Z motor 506) of this structure, a plurality of coils 501 are arranged at intervals (spaced apart) from each other in the horizontal direction, at positions spaced apart from upper surfaces (surfaces on the guide yoke 402 side) of the plurality of permanent magnets 502 in the vertical direction (in other words, separated from the plurality of permanent magnets 502 and the movable yoke 403 in the vertical direction). The plurality of coils 501 are molded with the molding resin 500. The plurality of coils 501 molded with the molding resin 500 are fixed to an upper surface formed around the recess (the portion to which the movable yoke 403 is fixed) provided in the coil fixing portion 602. That is, in the reluctance motor (Z motor 506) of this structure, the plurality of coils 501, the plurality of permanent magnets 502, and the movable yoke 403 are arranged in this order from an upper side to a lower side in the vertical direction below the guide yoke 402. The magnetic flux 108 generated by the permanent magnet 502 and the movable yoke 403 is formed in a loop shape inside the guide yoke 402 and the movable yoke 403, but as illustrated, directions of the magnetic fluxes 108 of the plurality of permanent magnets 502 are along the vertical direction and opposite to each other (the directions are different). The Z coil 501 is separated from the movable yoke 403 and the permanent magnet 502, is fixed to the coil fixing portion 602 formed of an aluminum member or the like having a higher thermal conductivity than the movable yoke 403 and the permanent magnet 502, is connected to the water cooling jacket 508, which is a heat discharging portion for discharging heat generated from the Z coil 501, via the coil fixing portion 602 and not via the movable yoke 403 or the permanent magnet 502, and can be provided with an efficient heat discharging path 601 from the Z coil 501 to the water cooling jacket 508. That is, by improving heat discharge characteristics of the Z motor 506, it is possible to restrict the temperature rise of the Z motor 506 and reduce the visual field deviation. It is also possible to prevent the thermal demagnetization by restricting the temperature rise of the permanent magnet 502.

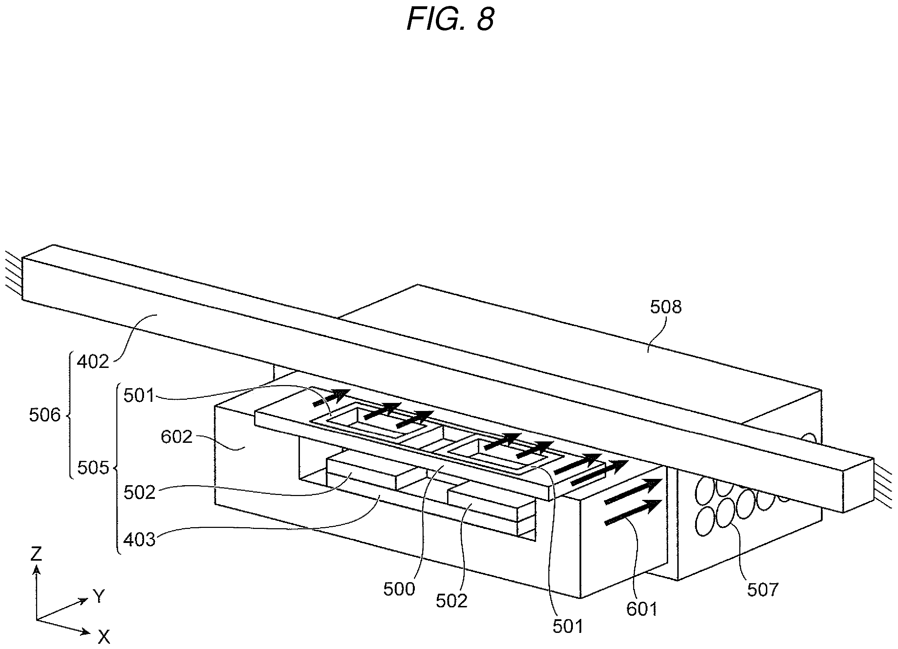

FIG. 8 illustrates details of a heat discharging structure of the reluctance motor according to the embodiment of the present disclosure. In FIG. 8, in order to facilitate understanding of the structure, a part of the molding resin 500 (portions on an upper surface side and an inner side of each coil 501, a portion between adjacent coils 501, and the like) is omitted. In order to enhance the effect of heat discharging to the water cooling jacket 508, it is preferable that the Z coils 501 (and the permanent magnets 502) are arranged side by side such that the X direction, which is a movable direction of the stage, is a longitudinal direction thereof, the water cooling jacket 508 is disposed in the Y direction (direction perpendicular to the direction in which the Z coils 501 are arranged side by side) with respect to the Z coil 501, and a heat transfer path from each of the Z coils 501 to the Y direction is shortened. By changing an attachment height of the movable yoke 403 to the coil fixing portion 602, the magnetic attraction force of the permanent magnet 502 to the guide yoke 402 can be finely adjusted, and it is possible to easily cope with specification changes such as mass changes of the levitation portion.

Next, a leakage magnetic field reduction effect of the Z motor of the present disclosure will be described.

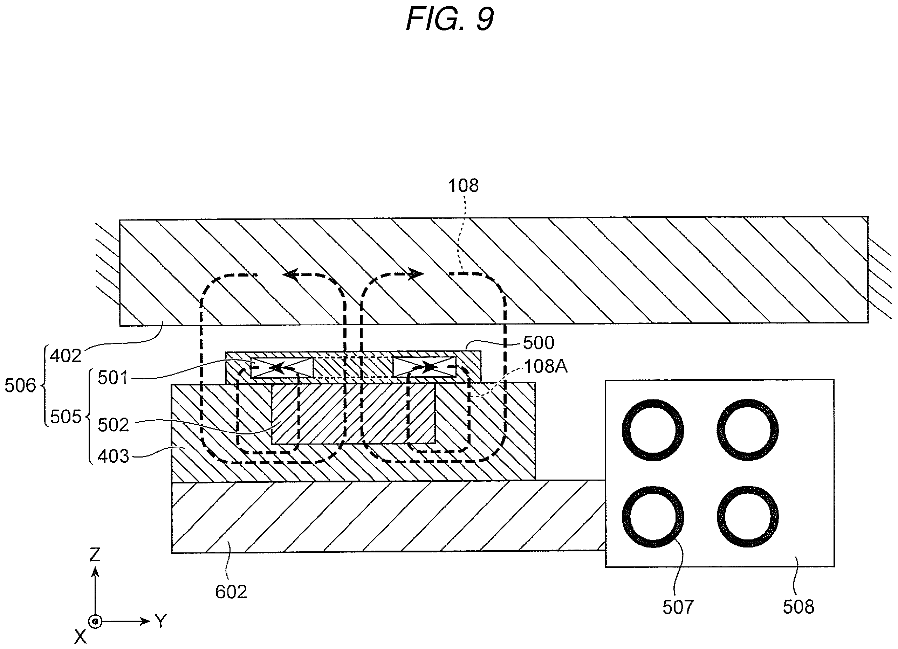

Generation of a leakage magnetic field in the case of the reluctance motor in the related art will be described with reference to FIG. 9. In the reluctance motor in the related art, a magnetic short-circuit 108A in which a magnetic flux circulates in the movable yoke 403 occurs in addition to the loop of the main magnetic flux 108. Accordingly, since the loop of the main magnetic flux 108 is weakened, the magnetic attraction force decreases, and it is necessary to increase a size of the permanent magnet 502 in order to compensate for the decrease. When the size of the permanent magnet 502 increases, the leakage magnetic field increases, and thus the size of the movable yoke 403 also needs to increase, which leads to an increase in mass of the movable portion. In that case, a vicious circle regarding an increase in size is caused in which, due to an increase in the magnetic attraction force for gravity compensation of the movable portion, a further increase in size of the permanent magnet 502 is required, and the mobility decreases due to an increase in mass of the movable portion.

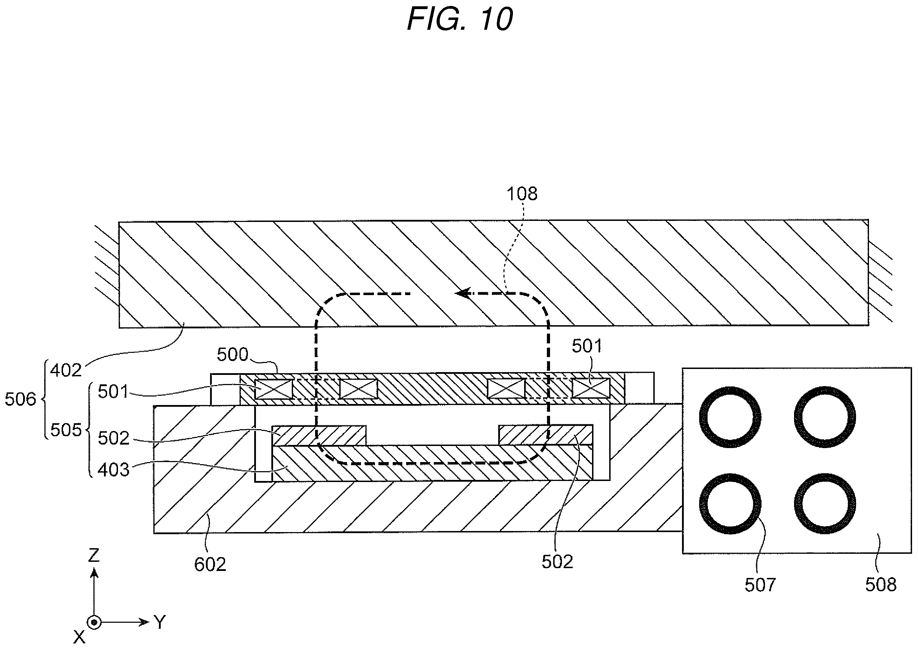

A magnetic field leakage reduction effect of the reluctance motor according to the embodiment of the present disclosure will be described with reference to FIG. 10. In the structure of the Z motor 506 of the embodiment, since the movable yoke 403 that is a magnetic material is not provided beside the permanent magnet 502, the magnetic short-circuit illustrated in FIG. 9 does not occur, and the size of permanent magnet 502 can be reduced. In the reluctance motor, the guide yoke 402 is provided above the permanent magnet 502 at a distance, and the movable yoke 403 relatively close to the permanent magnet 502 does not cover the permanent magnet 502 from above. Therefore, a leakage magnetic field above does not depend on the shape of the movable yoke 403 but depends only on a thickness of the permanent magnet 502. Therefore, in the Z motor 506 of the embodiment in FIG. 10, since the permanent magnet 502 can be reduced in size as compared with that of the Z motor in the related art in FIG. 9, the leakage magnetic field in the Z direction in which the sample 104 is present can be restricted to be low, and the Z motor 506 is suitable for a sample stage of a charged particle beam apparatus such as a scanning electron microscope.

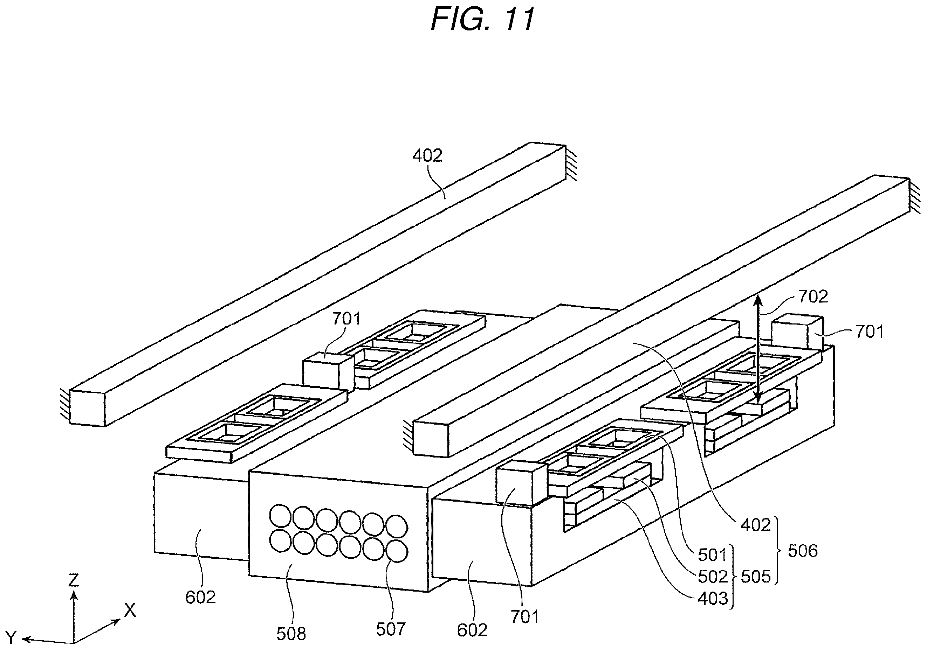

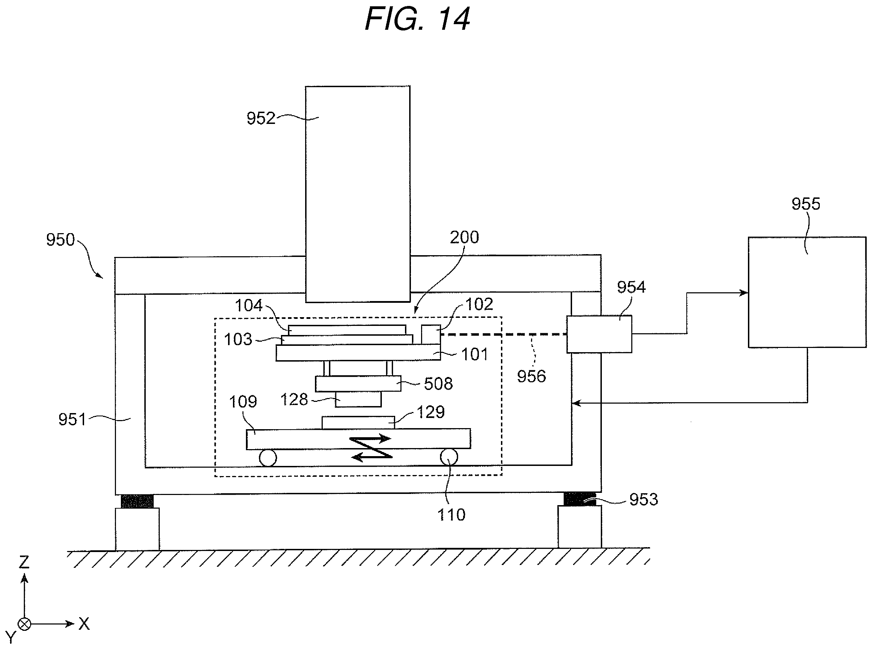

A mounting layout of the Z motor and a position reference block according to an embodiment of the present disclosure will be described with reference to FIG. 11. Four movable elements 505 of the Z motor 506, each of which includes the permanent magnet 502, the movable yoke 403, and the Z coil 501, are mounted so as to surround the water cooling jacket 508, and control a posture of the levitation portion around the X axis and the Y axis. In the magnetic levitation stage, in order to improve reproducibility of posture in a levitated state, an initialization operation of positioning a position reference block 701 by pressing the position reference block 701 against a lower surface of the guide yoke 402, which is a stator of the Z motor 506, is performed at the time of levitation initialization. The magnetic attraction force of the Z motor 506 responsible for gravity compensation fluctuates depending on a distance 702 between the permanent magnet 502 and the guide yoke 402 in the Z direction, and a difference between the magnetic attraction force and the gravity needs to be compensated by the thrust of the Z motor 506, which is an offset component of a current value of the Z coil 501. That is, in order to reduce the heat generation of the Z motor 506, it is necessary to make gravity compensation forces of four Z motors 506 constant, and it is necessary to improve the reproducibility of posture during the initialization operation. Therefore, a structure is adopted in which at least three position reference blocks 701 that define an interval (distance in the Z direction) between the movable element 505 (particularly, the permanent magnet 502) of the Z motor 506 and the guide yoke 402, which is the stator of the Z motor 506, are arranged near or around the Z motor 506, and a plane is defined with high reproducibility at at least three points. In order to restrict a change in a reference plane during the initialization operation, the material of the position reference block 701 may be resin to prevent damage to the lower surface of the guide yoke 402. The position reference block 701 may be installed at the coil fixing portion 602 near or around the Z motor 506 as illustrated, or may be installed at the guide yoke 402. In the case of a vacuum device (FIG. 14), PPS having good processability and outgassing characteristics may be used as the resin material.

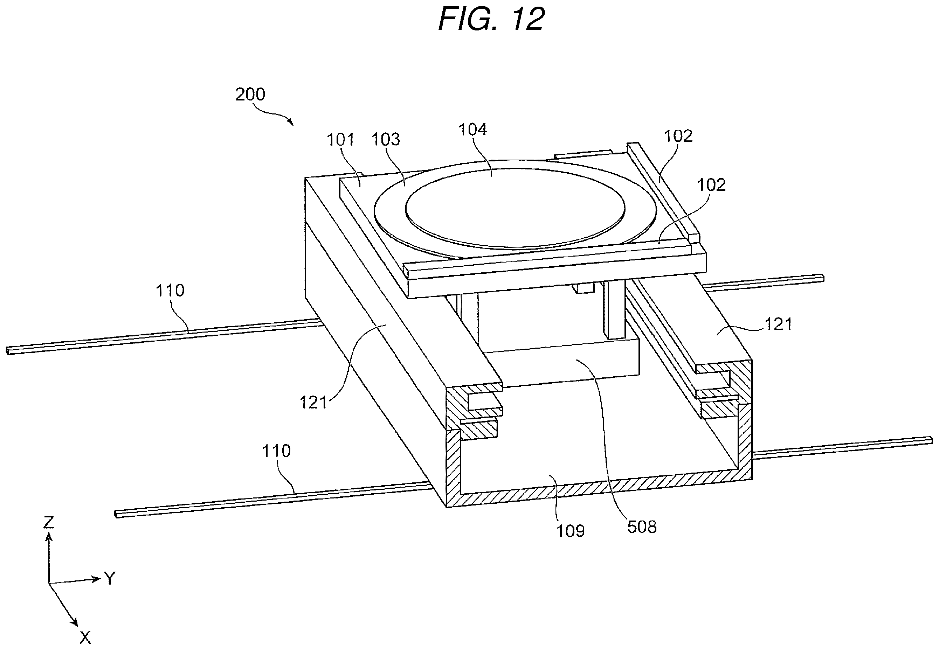

FIG. 12 illustrates a configuration example of a stacked stage in which a magnetic levitation guide is used on the X axis and a rolling guide is used on the Y axis. FIG. 12 illustrates a configuration example in which the uniaxial magnetic levitation stage shown in FIG. 3 is used as an upper shaft and the stage using the uniaxial rolling guide shown in FIG. 1 is used as a lower shaft. In a stage device 200 illustrated in FIG. 12, a portion corresponding to the base 119 in FIG. 3 is guided as a Y table 109 by a Y guide 110 so as to be movable in the Y direction. Accordingly, it is possible to implement a magnetic levitation stage having a long stroke in the X direction and the Y direction. A low-cost rolling guide may be used as the Y guide 110. It is also possible to adopt a stacked stage in which the Y guide 110 is a magnetic levitation guide so magnetic levitation guides are on both X and Y axes.

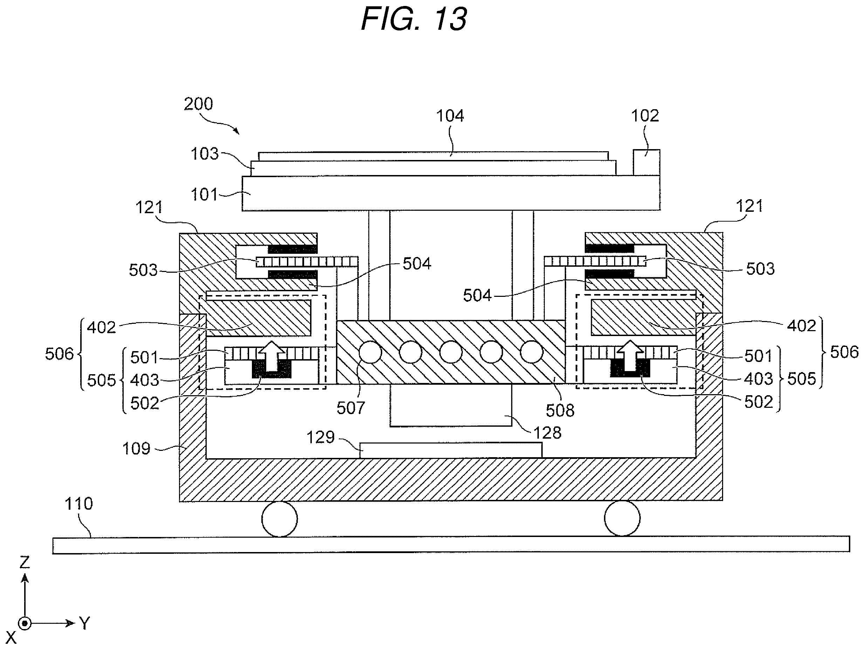

FIG. 13 is a schematic cross-sectional view in the YZ plane of the stacked stage shown in FIG. 12. In the example, the upper shaft is a magnetic levitation guide and the lower shaft is a rolling guide. The stage device 200 is implemented such that the Y guide 110 as a rolling guide is disposed below the Y table 109 having a U shape as viewed in the X direction.

Finally, an embodiment of the charged particle beam apparatus and the vacuum device according to the present disclosure will be described with reference to FIG. 14. FIG. 14 is a schematic cross-sectional view of a semiconductor measurement apparatus that is an embodiment of the charged particle beam apparatus and the vacuum device including a stage device in which a magnetic levitation stage having a temperature-stabilized Z motor of the present disclosure is mounted.

A semiconductor measurement apparatus 950, which is an embodiment of the charged particle beam apparatus and the vacuum device according to the present disclosure, includes the stage device 200 (FIG. 12 and FIG. 13) that positions an object 104, and a vacuum chamber 951 that accommodates the stage device 200. The stage device 100 (FIG. 3 and the like) may be used instead of the stage device 200. The semiconductor measurement apparatus 950 according to the embodiment is, for example, a length measurement SEM as an application device of a scanning electron microscope (SEM).

The semiconductor measurement apparatus 950 includes, for example, the stage device 200, the vacuum chamber 951, an electron optical system lens barrel 952, vibration damping mounts 953, a laser interferometer 954, and a controller 955. The vacuum chamber 951 accommodates the stage device 200, is depressurized inside by a vacuum pump (not shown), and is in a vacuum state having a pressure lower than an atmospheric pressure. The vacuum chamber 951 is supported by the vibration damping mounts 953.

The semiconductor measurement apparatus 950 positions the object 104 such as a semiconductor wafer by using the stage device 200 accommodated in the vacuum chamber 951, irradiates the object 104 with an electron beam from the electron optical system lens barrel 952, images a pattern on the object 104, and measures a line width of the pattern and evaluates shape accuracy. In the stage device 200, a position of the bar mirror 102 is measured by irradiating the bar mirror 102 with laser light 956 by the laser interferometer 954 and detecting reflected light thereof, a position of the scale plate 129 fixed to the Y table 109 is measured by the scale head 128, and the object 104 such as a semiconductor wafer held on the sample stage 103 of the top table 101 is positioned and controlled by the controller 955.

Since the semiconductor measurement apparatus 950 according to the embodiment includes the stage device 200 in which the temperature fluctuation of the Z motor 506 is small, it is possible to reduce the visual field deviation caused by thermal deformation due to motor heat generation at the time of positioning the object 104 such as a semiconductor wafer, and to restrict magnetic field leakage. Therefore, it is possible to improve visual field positioning accuracy of the semiconductor measurement apparatus 950 serving as the charged particle beam apparatus. Since the levitation mechanism of the stage device 200 is of a magnetic levitation type, the stage device 200 can be easily applied to the semiconductor measurement apparatus 950 that is a vacuum device, and can exhibit excellent effects such as reduction of contamination and restriction of heat generation. The charged particle beam apparatus and the vacuum device according to the present disclosure are not limited to the semiconductor measurement apparatus.

As described above, a stage device (100, 200) according to the embodiment includes: a base (119, 109); a stage (top table 101) configured to support the object 104 to be positioned on the base; and the Z-axis motor 506 configured to magnetically levitate and position the stage. The Z-axis motor 506 includes the guide yoke (stator) 402 provided on the base, and the movable element 505 provided on the stage so as to face the guide yoke 402 in a vertical direction. The movable element 505 includes: a plurality of magnets 502 that are arranged at intervals in a horizontal direction so as to face the guide yoke 402 in the vertical direction and whose magnetic fluxes 108 are oriented in the vertical direction and opposite to each other (have different directions); the movable yoke 403 covering a surface (bottom surface) of each of the plurality of magnets 502 on a side opposite to the guide yoke 402 side; and a plurality of coils 501 arranged at intervals in the horizontal direction, at positions spaced apart in the vertical direction from surfaces (upper surfaces) of the plurality of magnets 502 on the guide yoke 402 side. The Z-axis motor 506 magnetically levitates the stage (with respect to the base) by moving the movable element 505 in the vertical direction with respect to the guide yoke 402 by an electromagnetic force (magnetic attraction force 401) of the plurality of magnets 502 and the guide yoke 402 when a current is applied to the plurality of coils 501 (by energization of the plurality of coils 501).

Below the guide yoke 402, the plurality of coils 501, the plurality of magnets 502, and the movable yoke 403 of the movable element 505 are arranged in this order from above in the vertical direction.

The movable yoke 403 covers only the surface (bottom surface) of each of the plurality of magnets 502 on the side opposite to the guide yoke side.

The plurality of coils 501 are connected to the coil fixing portion 602 having a thermal conductivity higher than that of the movable yoke 403 (and the plurality of magnets 502), and are connected to a heat discharging portion (water cooling jacket 508 and the like) configured to discharge heat generated from the plurality of coils 501, via the coil fixing portion 602 and not via the movable yoke 403 (or the plurality of magnets 502).

The movable yoke 403 is connected to the coil fixing portion 602, and (bottom surfaces of) the plurality of magnets 502 are connected to (upper surface of) the movable yoke 403 without contacting the coil fixing portion 602.

The plurality of magnets 502 and the plurality of coils 501 are arranged side by side in a movable direction of the stage, and the heat discharging portion is disposed in a direction perpendicular to a direction in which the plurality of magnets 502 and the plurality of coils 501 are arranged side by side.

That is, in the embodiment, the bottom surfaces of the plurality of magnets 502 are coupled by the movable yoke 403 to form a magnetic circuit, and the plurality of coils 501 are detached (separated) from the movable yoke 403 and fixed to the coil fixing portion 602 that is a heat discharging path member, so that thermal deformation due to temperature fluctuation of the levitation portion is restricted, thereby providing a stage device, a charged particle beam apparatus, and a vacuum device capable of highly accurate positioning and having a small leakage magnetic field. In other words, in the Z-axis motor 506 used for gravity compensation and thrust generation in the vertical direction of the magnetic levitation stage, the movable yoke 403 covering the bottom surfaces of the plurality of magnets 502 whose magnetic fluxes are directed in the vertical direction and are different in direction is provided, and the plurality of coils 501 are arranged separately from the movable yoke 403 and at intervals from the plurality of magnets 502.

According to the embodiment, it is possible to provide a stage device, a charged particle beam apparatus, and a vacuum device capable of performing highly accurate positioning by restricting thermal deformation due to temperature fluctuation of a levitation portion and capable of performing positioning while restricting leakage and fluctuation of a magnetic field.

Although the embodiments of the invention have been described in detail with reference to the drawings, specific configurations are not limited to the embodiments, and if design changes and the like may be made without departing from the gist of the invention, the changes are included in the invention.

## Claims

1. A stage device comprising:
a base;
a stage configured to support an object to be positioned on the base; and
a Z-axis motor configured to magnetically levitate and position the stage, wherein
the Z-axis motor includes
a guide yoke provided on the base, and
a movable element provided on the stage so as to face the guide yoke in a vertical direction,
the movable element includes
a plurality of magnets that are arranged at intervals in a horizontal direction so as to face the guide yoke in the vertical direction and whose magnetic fluxes are oriented in the vertical direction and are opposite to each other,
a movable yoke covering a surface of each of the plurality of magnets on a side opposite to a guide yoke side, and
a plurality of coils arranged at intervals in the horizontal direction, at positions spaced apart in the vertical direction from surfaces of the plurality of magnets on the guide yoke side, and
the Z-axis motor magnetically levitates the stage by moving the movable element in the vertical direction with respect to the guide yoke by an electromagnetic force of the plurality of magnets and the guide yoke.

2. The stage device according to claim 1, wherein
below the guide yoke, the plurality of coils, the plurality of magnets, and the movable yoke of the movable element are arranged in this order from above in the vertical direction.

3. The stage device according to claim 1, wherein
the movable yoke covers only the surface of each of the plurality of magnets on the side opposite to the guide yoke side.

4. The stage device according to claim 1, wherein
the plurality of coils are connected to a coil fixing portion having a thermal conductivity higher than that of the movable yoke, and are connected to a heat discharging portion configured to discharge heat generated from the plurality of coils, via the coil fixing portion and not via the movable yoke.

5. The stage device according to claim 4, wherein
the movable yoke is connected to the coil fixing portion, and the plurality of magnets are connected to the movable yoke without being in contact with the coil fixing portion.

6. The stage device according to claim 4, wherein
the plurality of magnets and the plurality of coils are arranged side by side in a movable direction of the stage, and the heat discharging portion is disposed in a direction perpendicular to a direction in which the plurality of magnets and the plurality of coils are arranged side by side.

7. The stage device according to claim 1, wherein
at least three position reference blocks that define an interval between the movable element and the guide yoke are arranged around the Z-axis motor.

8. A charged particle beam apparatus comprising:
the stage device according to claim 1.

9. A vacuum device comprising:
the stage device according to claim 1.
